# EUROPÄISCHE PATENTSCHRIFT

(11) **EP 1 709 693 B1**
(45) Veröffentlichungstag und Bekanntmachung des Hinweises auf die Patenterteilung: **06.06.2012**
(21) Anmeldenummer: 05701194.2
(22) Anmeldetag: 26.01.2005
(51) Int. Cl.: H01L 25/075, H01L 33/08, H01L 27/15

(54) **Lichtemittierende Zonen aufweisende Halbleiterstruktur mit Absorptionsschicht**
Semiconductor structure comprising light-emitting zones and absorption layer
Structure à semi-conducteurs présentant des zones électroluminescentes et couche d'absorption

(30) Priorität: 29.01.2004 DE 102004004765
(43) Veröffentlichungstag der Anmeldung: 11.10.2006
(73) Patentinhaber: AZUR SPACE Solar Power GmbH, 74072 Heilbronn (DE)
(72) Erfinder: BENSCH, Werner, 74226 Nordheim (DE)
(74) Vertreter: Stoffregen, Hans-Herbert
(86) Internationale Anmeldenummer: PCT/EP2005/000759
(87) Internationale Veröffentlichungsnummer: WO 2005/073485

(56) Entgegenhaltungen:
- EP-A- 0 649 202
- EP-A- 0 727 830
- WO-A-00/77861
- WO-A-97/23912
- US-A- 5 166 761
- US-A- 5 739 552
- CONTOUR J P ET AL: "(GaAl)As tunnel junctions grown by molecular beam epitaxy: intercell ohmic contacts for multiple-band-gap solar cells" SOLAR CELLS SWITZERLAND, Bd. 13, Nr. 1, November 1984 (1984-11), Seiten 67-76, XP002345448 ISSN: 0379-6787
- "High-efficiency high-brightness multiple active district tunnel reclaimed white light light emitting diodes" CHINESE PATENT OFFICE PUBLISHED PATENT APPLICATION, [Online] Nr. CN1490888, 21. April 2004 (2004-04-21), XP002355121 Gefunden im Internet: URL:http://211.157.104.67/sipoasp/e-zljs/h yjs-yx.asp?recid=0&ResultID=1> [gefunden am 2005-11-18] & US 2005/067627 A1 (SHEN GUANGDI ET AL) 31. März 2005 (2005-03-31)

## Beschreibung

Die Erfindung bezieht sich auf eine aktive Zonen aufweisende Halbleiterstruktur nach dem Oberbegriff des Anspruchs 1 oder dem Oberbegriff des Anspruchs 2.

Eine aktive Zonen aufweisende Halbleiterstruktur nach dem Oberbegriff des Anspruchs 1 ist beispielsweise in dem Aufsatz von J. P. Contour u.a. "(GaAl)As tunnel junctions grown by molecular beam epitaxy: intercell ohmic contacts for multiple-band-gap solar cells", IEE, Stevenage, GB, November 1984, bekannt. Beschrieben ist eine Halbleiterstruktur mit epitaktisch aufgewachsenen, aufeinander liegenden und durch Trenndiode verbundenen optoelektronisch aktiven Zonen, wobei jede aktive Zone eine höhere energetische Bandlücke aufweist als eine darunter liegende aktive Zone, und die Halbleitermaterialien der Trenndioden eine energetische Bandlücke aufweisen, die jeweils etwas höher liegt als die der darunter liegenden verwendeten Halbleitermaterialien.

Aus der US-A-5,166,761 ist ebenfalls eine Multiwavelength-Diode mit einer monolithischen kaskadierten Zellstruktur bekannt, umfassend zumindest zwei p-n-Übergänge, wobei jede der zumindest zwei p-n-Übergänge im Wesentlichen unterschiedliche Bandlücken aufweist und elektrische Verbindungsmittel durch die die zumindest zwei p-n-Übergänge gemeinsam mit Energie versorgt werden und wobei die Diode einen Tunnelübergang umfasst.

Eine aktive Zonen aufweisende Halbleiterstruktur nach dem Oberbegriff des Anspruchs 2 ist in der EP-B-0 649 202 beschrieben. Diese bezieht sich auf einen Halbleiterlaser und dessen Herstellungsverfahren. Der Halbleiterlaser besteht aus einer Vielzahl von durch Löten derart übereinander geschichteten Halbleiterchips, dass ihre Laserabstrahlungsoberflächen koplanar zueinander angeordnet sind, wobei jeder Laserchip ein Substrat mit darauf aufgebrachten Epitaxierschichten einschließlich einer aktiven Schicht aufweist.

Eine weitere aktive Zonen aufweisende Halbleiterstruktur ist in einem Aufsatz von I. Ozden et al.: "A dual-wavelength indium gallium nitride quantum well light emitting diode" in Applied Physics Letters, Vol. 79, Nr. 16, 2001, S. 2532 - 2534, beschrieben. Dabei handelt es sich um eine monolithische, Zweifachwellenlängen (Blau/grün) licht-emittierende Diode (LED) mit zwei aktiven Indium-Gallium-Nitrid/Galliumnitrid (In-GaN/GaN) Mehrfachquantentopf-Segmenten. Die Segmente sind Teil einer einzelnen vertikalen Epitaxialstruktur, in der ein p⁺⁺/n⁺⁺/InGaN/GaN Tunnelübergang zwischen den LED's eingefügt ist. Die Segmente emittieren jeweils bei 470 nm und 535 nm.

Die EP-A-1 403 935 offenbart eine lichtemittierende Diode mit einem ersten aktiven Bereich, einem zweiten aktiven Bereich und einem Tunnelübergang. Der Tunnelübergang umfasst eine Schicht aus einem ersten leitfähigen Typ und eine Schicht aus einem zweiten leitfähigen Typ, die beide dünner sind als eine Schicht eines ersten leitfähigen Typs und eine Schicht eines zweiten leitfähigen Typs, welche den ersten aktiven Bereich umgeben. Der Tunnelübergang erlaubt die vertikale Stapelung der aktiven Bereiche, wodurch das durch das Element erzeugte Licht ohne Vergrößerung der Größe der Lichtquelle gesteigert werden kann.

Die EP-A-0 727 830 bezieht sich auf ein Verfahren zur Herstellung einer lichtemittie-renden Diode (LED) mit einer Mehrzahl von Schichten umfassend angrenzende erste und zweite Schichten, die an einem Zwischenstück verbunden sind. Die Herstellung kann nach dem Waver-Bonding-Verfahren durchgeführt werden. Multiple LED-Strukturen können mit anderen Schichten verbunden werden, wenn die Zwischenschicht derart ausgebildet ist, dass eine hohe elektrische Leitfähigkeit durch das Element gewährleistet ist. Der Dotierungstyp der Schichten der oberen LED-Struktur entspricht dem Dotierungstyp der Schichten der unteren LED-Struktur. Somit werden die beiden LED-Strukturen mit derselben Polarität zueinander angeordnet. Die miteinander zu verbindenden (Wafer-Bonding) Oberflächen sollten sehr hoch dotiert sein. Wenn die Strukturen gebondet werden, wird ein hochdotierter Tunnelübergang mit entgegengesetzter Polarität der LED's gebildet. Alternativ wird vorgeschlagen, dass der Tunnelübergang epitaktisch aufgewachsen wird.

Aus der WO-A-00/77861 ist eine aktive Zonen aufweisende Halbleiterstruktur bekannt, umfassend eine Vielzahl auf verschiedene Wellenlängen selektive aktive Schichten, die in einem vertikalen Stapel auf einem Substrat angeordnet sind, so dass dem einfallenden Licht ermöglicht wird, die Schichten mit gleichförmig abfallenden Bandlücken zu durchqueren- Photonen unterschiedlicher Energie werden dabei selektiv absorbiert oder von den aktiven Schichten emittiert. Kontaktmittel sind separat an den äußeren Seiten jeder Schicht oder einem Satz von Schichten mit den gleichen Parametern angeordnet zum Abführen von Ladungen, die in den photonen-absorbierenden Schichten erzeugt werden und/oder Einleiten von Ladungsträgern in die photonenemittierenden Schichten. Einsatzzweck für dieses Element sind beispielsweise Displays oder Solarzellen.

Aus der WO 99/57788 ist eine weitere lichtemittierende Halbleitereinrichtung der oben genannten Art bekannt. Dort wird eine zweifarbige LichtemissionsHalbleitereinrichtung beschrieben, die zwischen ihrer Vorderseite und ihrer Rückseite eine erste oberflächenemittierende Lichtemissionsdiode mit einer ersten aktiven Zone, welche die Strahlung einer ersten Wellenlänge emittiert, und einer zweiten oberflächen-emittierenden Lichtemissionsdiode mit einer zweiten aktiven Zone aufweist, welche die Strahlung einer zweiten Wellenlänge emittiert, wobei zwischen beiden aktiven Zonen eine erste Reflektionsschicht angeordnet ist, die für die erste Wellenlänge reflektierend und für die zweite Wellenlänge durchlässig ist. Ferner ist vorgesehen, dass zwischen der zweiten aktiven Zone und der Rückseite eine zweite Reflektionsschicht angeordnet ist, die für die zweite Wellenlänge reflektierend ist. Die Reflektionsschichten bewirken eine bessere Ausnutzung des in Richtung auf die Rückseite aufgestrahlten Lichtes beider Dioden und sind vorzugsweise aus einem Mehrfachschichtsystem aus Schichten mit abwechselnd hohem und niedrigem Brechungsindex gebildet, wobei die Schichten vorzugsweise aus einem Gitter angepassten Halbleitermaterial aufgebaut sind.

Bei der bekannten Halbleitereinrichtung sind die aktiven Zonen auf zwei gegenüberliegenden Oberflächen eines Substrates aufgebracht, so dass eine von der unteren aktiven Zone emittierte Lichtstrahlung das Substrat sowie zumindest eine Reflektionsschicht durchqueren muss, wodurch optische Verluste möglich sind. Des Weiteren sind mit der bekannten Lichtemissionshalbleitereinrichtung lediglich zwei Lichtstrahlungen erzeugbar. Dem Einsatz als Farbdisplay sind damit Grenzen gesetzt.

Davon ausgehend liegt der vorliegenden Erfindung das Problem zu Grunde, eine licht emittierende Zonen aufweisende Halbleiterstruktur derart weiterzubilden, dass eine Intensitätsanpassung von emittiertern Licht der jeweiligen aktiven Zone erreicht wird.

Das Problem wird erfindungsgemäß dadurch gelöst, dass auf eine licht emittierende Zone eine Absorptionsschicht mit gleichem Material der pn-Schicht der licht emittierenden Zone aufgewachsen ist. Dies geschieht zum Zweck der Intensitätsanpassung von emittiertem Licht der jeweiligen licht emittierenden Zone im Falle der seriellen Verschaltung.

Mit der erfindungsgemäßen lichtemittierenden Halbleitereinrichtung, die auch als Multi-Wavelength-Diode bezeichnet werden kann, können mehrere Photonen-Emissions-Peaks unterschiedlicher Wellenlänge innerhalb eines Chips erzeugt werden. Das Prinzip beruht darauf, dass auf einem geeigneten Substrat epitaktische Halbleitermaterialien aufgewachsen werden. Die lichtemittierenden, als pn- oder np-Übergänge ausgebildeten aktiven Zonen werden in dem Chip von unten nach oben seriell verschaltet. Dabei erfolgt die Verschaltung epitaktisch über Trennschichten wie beispielsweise Trenndioden, die als niederohmige Widerstände verwendet werden. Diese Trenndioden bestehen aus einem np- oder pn-Übergang, an dem eine nur sehr geringe entgegengerichtete Spannung abfällt.

Die alternative Ausführungsform sieht vor, dass als Zwischenschicht ein leitfähiger, z. B. metallischer Kontakt für die serielle Verschaltung eingesetzt ist.

Es ist vorgesehen, dass das Material des Substrates GaAs, Ge, InP, GaSb, GaP, InAs, Si, SiGe, SiC, SiGe : C, Saphir oder Diamant ist.

Des Weiteren ist vorgesehen, dass das Material der licht emittierenden Zonen GaAs, GaInP (geeignete Kompositionen), AlGaAs (viele geeignete Kompositionen), GalnAs (geeignete Kompositionen), AlInGaP (viele geeignete Kompositionen), GaAsN, GaN, GaInN, InN, GaInAlN (geeignete Kompositionen), GaAlSb, GaInAlSb, CdTe, MgSe, MgS, 6HSiC, ZnTe, CgSe, GaAsSb, GaSb, InAsN, 4H-SiC, a - Sn, BN, BP, BAs, AlN, ZnO, ZnS, ZnSe, CdSe, CdTe, HgS, HgSe, PbS, PbSe, PbTe, HgTe, HgCdTe, CdS, ZnSe, InSb, AlP, AlAs, AlSb, InAs und/oder AlSb ist oder eine oder mehrere dieser Materialien enthält.

Eine Bandemissionsdiode zeichnet sich durch folgenden Aufbau aus:
- ein GaAs- oder Ge-Substrat,
- eine auf das Substrat aufgewachsene GaAs-Diode (untere Diode),
- darüber in abwechselnder Reihenfolge eine auf die GaAs-Diode aufgewachsene Trenndiode wie GaInP-Trenndiode bzw. AlGaAs-Trenndiode gefolgt von einer auf die Trenndiode aufgewachsenen GaInP-Diode bzw. AlGaAs-Diode, wobei die Anzahl der Dioden (AZl - AZn) die Anzahl der Peaks einen Bandemissionsbereich definiert.

Der Bandemissionsbereich ist dadurch definiert, dass die Anzahl der Dioden, die Anzahl sowie deren Breite der Peaks einen zusammenliegenden Lichtemissionsbereich ausbildet, in der Art, wie er durch einen einzelnen Peak nicht erreicht werden könnte, somit einen resultierenden Emissionsbereich erhält.

Auch können die einzelnen licht emittierenden Zonen jeweils mit einem eigenen metallischen Kon-takt zum Anschluss einer Zuleitung versehen sein für den Fall, dass jede oder ausgesuchte einzelne licht emittierende Zonen separat angesteuert werden sollen.

Eine Mischfarben-LED der Farbe braun mit nur einem Chip weist vorzugsweise folgenden Aufbau auf:
- ein GaA- oder Ge-Substrat,
- eine auf das Substrat aufgewachsene untere licht emittierende Zone aus z. B. GaInP (auch AlGaInP), deren geeignete Emissisonswellenlänge im roten Bereich liegt, eine erste auf die untere licht emittierende Zone aufgewachsene Trenndiode aus GaInP oder AlGaInP, deren Bandenergie höher liegt als die der darunterliegenden aktiven Zone,

- eine auf die Trenndiode aufgewachsene mittlere licht emittierende Zone aus AlInGaP, deren Emissionswellenlänge im gelben Bereich liegt,
- eine zweite Trenndiode und deren Bandenergie unter der Bandenergie der darunter liegenden licht emittierenden Zone liegt und H
- eine auf die zweite Trenndiode aufgewachsene obere licht emittierende Zone aus AlInGaP, deren Emissionswellenlänge im grünen Bereich liegt.

Eine weitere bevorzugte Ausführungsform zeichnet sich dadurch aus, dass eine Mischfarben-LED umfasst:
- ein GaAs- oder Ge-Substrat (SUB),
- eine auf das Substrat aufgewachsene untere licht emittierende Zone (AZ1) gefolgt von zwei weiteren licht emittierenden Zonen (AZ2 -AZn) zwischen denen jeweils eine Tunneldiode (TD1 - TDn) angeordnet ist und wobei die obere licht emittierende Zone (AZn) einen metallischen Kontakt (K) zur Verbindung mit einem elektrischen Anschluss aufweist.

Dabei kann vorgesehen sein, dass der zwischen den licht emittierende Zonen angeordneten Metallkontakt geklebt, gelötet, gedrückt, gebondet oder geschweißt ist.

Ein Teil der gewünschten Mischfarben werden durch 1-Chip-Bauteile mit unterschiedlichen licht emittierende Zonen mit Trenndioden erzeugt, ein zweiter Teil der gewünschten Mischfarben werden durch einen anderen Chip erzeugt, wobei die aktiven Zonen über eine metallische Verbindung zusammengefügt werden. Somit entsteht das gesamte Spektrum der gewünschten Mischfarben.

In einer besonders bevorzugten Ausführungsform ist vorgesehen, dass die untere licht emittierende Zone aus einem AlInGaP-Material mit einer Wellenlänge von ca. 620 nm ist, dass die mittlere licht emittierende Zone ein AlInGaP-Halbleitermaterial mit einer Wellenlänge von ca. 550 nm ist und dass die obere licht emittierende Zone ein GaInN-Halbleitermaterial mit einer Wellenlänge im Bereich von ca. 400 bis 450 nm ist. Bei dieser Ausführungsform entsteht die Mischfarbe "weiß" aus einem einzigen Chip.

Schließlich bezieht sich die Erfindung darauf, dass die aktive Zonen aufweisende Halbleiterstruktur ein Farbdisplay bildet. Dabei kann das FarbdispJay aus einer Vielzahl von lichtemittierenden Halbleitereinrichtungen gemäß vorliegender Erfindung bestehen, wobei ein Pixel des Farbdisplays einer lichtemittierenden Halbleitereinrichtung entspricht und wobei jeder Pixel und die entsprechenden Farben selektiv ansteuerbar sind.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von den Zeichnungen zu entnehmenden bevorzugten Ausführungsbeispielen.

Es zeigen:
- Fig. 1a, b: einen schematischen Aufbau einer Zwei-Peak-Diode mit zugehöriger Wellenlängen-Intensitätsverteilung,
- Fig. 2: eine Übersicht über Materialeigenschaften verschiedener Halbleitermaterialien,
- Fig. 3a, b: eine beispielhafte Bandemissionsdiode mit zugehöriger beispielhafter Wellenlängen-Intensitätsverteilung
- Fig. 4a, b: die beispielhafte Bandemissionsdiode gemäß Fig. 3 mit einer zwischen einer aktiven Zone und einer Trenndiode angeordneten Absorptionsschicht und beispielhaften Wellenlängen-Intensitätsverteilung,
- Fig. 5: einen schematischen Aufbau einer beispielhaften Mehrfach-Wellenlängen-Diode mit explizit ansteuerbaren licht emittierenden Zonen,
- Fig. 6a, b: einen schematischen Aufbau einer beispielhaften Mischfarben-Leuchtdiode (braun) mit beispielhafter Wellenlängen-Intensitätsverteilung,
- Fig. 7a, b: einen beispielhaften schematischen Aufbau einer Mischfarben-Leuchtdiode (weiß) mit beispielhafter Wellenlängen-Intensitätsverteilung,
- Fig. 8a, b: einen schematischen Aufbau einer beispielhaften Mehrfach-Peak-Leuchtdiode mit Trenndioden-Kontakten bzw. Metallkontakten und beispielhaften Wellenlängen-Intensitätsverteilung,
- Fig. 9: einen schematischen Aufbau einer Halbleiterstruktur mit getrennt ansteuerbaren Diodenaufbauten,
- Fig. 10: einen schematischen Aufbau einer Halbleiterstruktur mit getrennt ansteuerbaren Diodenaufbauten und
- Fig. 11: einen schematischen Aufbau eines Farbdisplays.

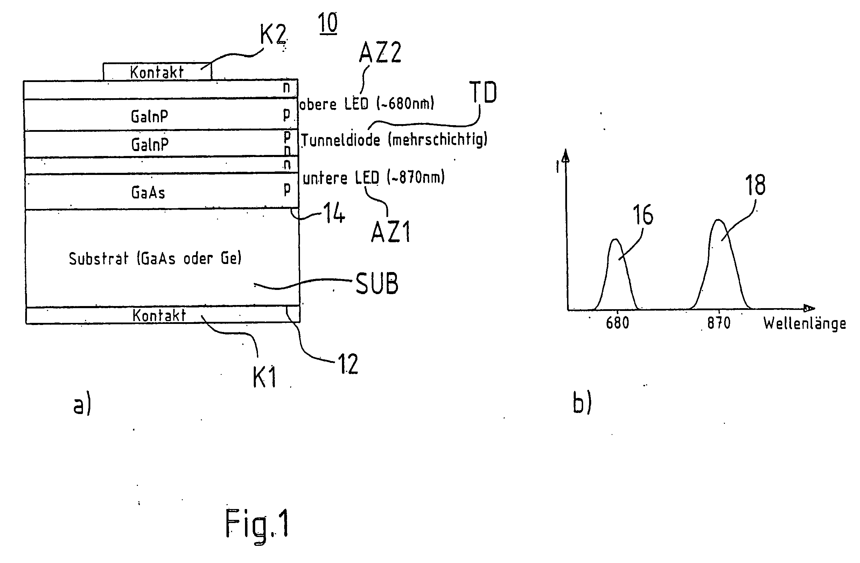

Fig. 1 zeigt einen schematischen Aufbau einer licht emittierende Zonen AZ aufweisenden Halbleiterstruktur 10, die als Zwei-Peak-Leuchtdiode bezeichnet werden kann. Die Zwei-Peak-Diode 10 umfasst ein Substrat SUB, welches beispielsweise aus GaAs- oder GeMaterial besteht. Eine untere Oberfläche 12 des Substrates SUB ist mit einem metallischen Kontakt K1 versehen, wobei auf einer oberen Oberfläche 14 eine erste (untere) licht emittierende Zone AZ1 als beispielsweise GaAs-Diode aufgewachsen ist. Über der unteren licht emittierende Zone AZ1 ist eine Trennschicht TD1 als Trenndiode beispielsweise GaInP-Trenndiode angeordnet, die eine Dicke im Bereich von ca. 40 nm aufweist. Diese Trenndiode TD dient als und wirkt wie ein niederohmiger Verbindungswiderstand für die scrielle Verschaltung der als pn-Übergang ausgebildeten unteren licht emittierende Zonen AZ1. Über die Tunneldiode TD wird eine weitere, obere licht emittierende Zone AZ2 gewachsen, die beispielsweise als GaInP-Diode ausgebildet ist. Der Fig. 1b ist eine beispielhafte spektrale Verteilung zu entnehmen, wobei ein erster Peak 16 im Bereich der Wellenlänge 680 nm liegt (GaInP) und ein zweiter Peak 18 im Bereich der Wellenlänge 870 nm (GaAs).

Die für den Aufbau der erfindungsgemäßen Halbleitereinrichtung verwendeten Halbleitermaterialien werden vorzugsweise nach folgenden Kriterien bestimmt:
- epitaktisches Wachstum auf dem Substrat SUB wird ermöglicht,
- geeignete Bandlücke und geeignetes Dotierniveau, welches die gewünschte Emissionswellenlänge erzeugt,
- Der unterste pn-Übergang AZ1 weist die kleinste energetische Bandlücke für die Lichterzeugung auf, die darüber liegenden als pn-Übergänge ausgebildeten lichtemittierende Zonen AZ1 bis AZn weisen jeweils höhere energetische Bandlücken auf, da ansonsten die emittierte Strahlung der darunter liegenden Diode LED1 absorbiert wird,
- die Bandlücke der Halbleitermaterialien, aus dem die Trenndiode TD hergestellt wird, sollte ebenfalls höher sein als die energetische Bandlücke der darunter lie-genden lichtemittierende Zone AZₓ, da ansonsten auch dort Absorption stattfindet, wobei die Trenndiode TD idealerweise aus einem indirekten Halbleiterübergang besteht,
- epitaktisches, kristallines Wachstum der verwendeten Halbleitermaterialien auf die darunter liegende Schicht.

Eine in Fig. 1a schematisch dargestellte licht emittierend Zonen aufweisende Halbleiterstruktur 10 stellt die Grundlage dar, auf der eine Reihe von Gestaltungsmöglichkeiten aufgebaut werden können. So können z. B. Mehr-Peak-Dioden hergestellt werden, die auf einen bestimmten Anwendungsfall abgestimmt werden. Ferner können Bandemissionsdioden hergestellt werden, die von einer bestimmten Anfangswellenlänge zu einer bestimmten Endwellenlänge quasi kontinuierlich Licht emittieren. Des Weiteren können Mischfarben-LED's mit nur einem Chip hergestellt werden.

Im Folgenden werden weitere schematische Aufbauten von Multi-Wavelenght-Dioden erläutert.

Aus der beispielhaften epitaktischen Landkarte können beispielhaft geeignete Materialsysteme entnommen werden. So kann das Substrat SUB beispielsweise als GaAs-Substrat oder als Ge-Substrat gewählt werden. Darauf eignen sich z. B. für ein epitaktisches Wachstum licht emittierend Zonen AZ Materialien wie GaAs, GaInP (geeignete Kompositionen), AlGaAs (viele geeignete Kompositionen), GaInAs (geeignete Komposition), AlInGaP (viele geeignete Kompositionen) oder sogar GaAsN, GaN, InN, GaInN, GaInAlN (geeignete Kompositionen), GaAlSb, GaInAlSb, CdTe, HgTe, HgCdTe, CdS, ZuSe, InSb, AlP, AlAs, AlSb, InAs, AlSb, MgSe, MgS, 6HSiC, ZnTe, CdSe, GaAsSb, GaSb, InAsN, 4H-SiC, α - Sn, BN, BP, BAs, AlN, ZnO, ZnS, ZnSe, CdSe, CdTe, HgS, HgSe, PbS, PbSe, PbTe.

Auch können andere Substrate SUB verwendet werden, wie z. B. InP, GaSb, InAs, Si, GaP, Diamant, Saphir, SiGe, SiC, SiGe: C und viele mehr.

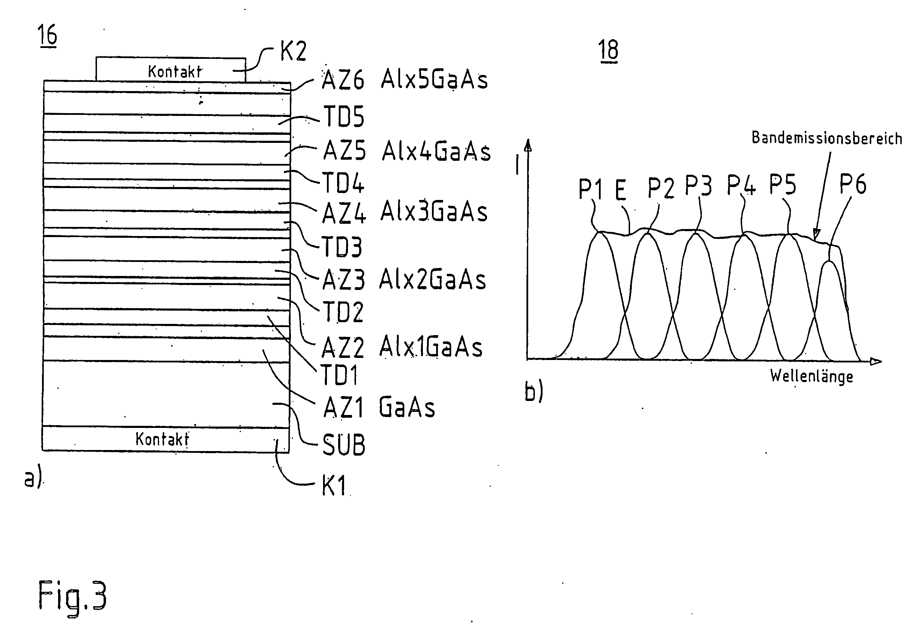

In Fig. 3 ist rein schematisch der Aufbau einer beispielhaften Bandemissionsdiode 16 dargestellt. Die Bandemissionsdiode 16 umfasst ein Substrat SUB wie GaAs-oder Ge-Substrat mit einem unteren Kontakt K1 und einer auf dem Substrat aufgewachsenen licht emittierende Zonen AZ1 als GaAs-Diode (untere Diode). Auf der LEDlist eine Trenndiode TD als niederohmiger Verbindungswiderstand für die serielle Verschaltung zu der nächsten LED2 vorgesehen. Die Trenndiode TD1 besteht aus AlGaAs oder GaInP. Darüber wird die nächste licht emittierende Zone AZ2 als pn-Übergang gewachsen (AlGaAS-Diode mit wenig Al-Gehalt). Anschließend wird wieder eine np-Trenndiode TD2 eingesetzt, so dass sich schließlich Trenndioden TD und aktive Zonen AZ abwechseln. Auf der obersten licht emittierende Zone AZ6 (beispielhaft) ist ein Kontakt K2 vorgesehen.

Eine spektrale Verteilung 18 ist in Fig. 3b dargestellt, die den Verlauf von sechs Peaks P1 -P6 und die daraus entstehende Einhüllende E, die gleichzeitig den Bandemissionsbereich darstellt.

Verwendet man beispielhaft eine GaAs-Diode mit einem Wellenlängenbereich λ = 870 nm als untere licht emittierende Zone AZ1, darauf folgend eine AlGaAs-Diode (λvon 875625 nm einstellbar) als TD1 und darauf folgend geeignete Kompositionen im AlInGaP-Mischkristallsystem (λ von 650 nm bis 540nm einstellbar), so kann ein Bandemissionsbereich E von λ = 870 nm bis 540 nm hergestellt werden. Dies bedeutet eine Bandemission von infrarot bis grün.

Dieses Konzept erlaubt auch die Herstellung von Bandemissionsdioden mit freien Bereichen, d. h. Emissionslöchern.

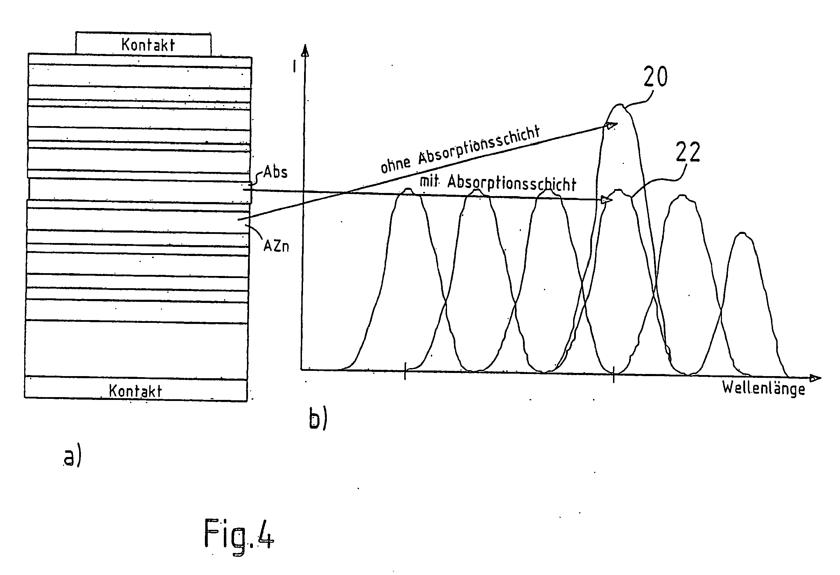

Falls die Intensität einer einzelnen licht emittierende Zone AZn (Leuchtdiode) - wie in Fig. 4a, b dargestellt - einen helleren bzw. intensiveren Peak 20 zeigt, besteht die Möglichkeit, unmittelbar über der aktiven Zone eine Absorptionsschicht ABS geeigneter Dicke und aus dem gleichen Material zu placieren, aus dem die pn-Schicht AZn besteht.

Fig. 4b zeigt den Peak 20 ohne Absorptionsschicht und einen korrigierten Peak 22 mit Absorptionsschicht ABS.

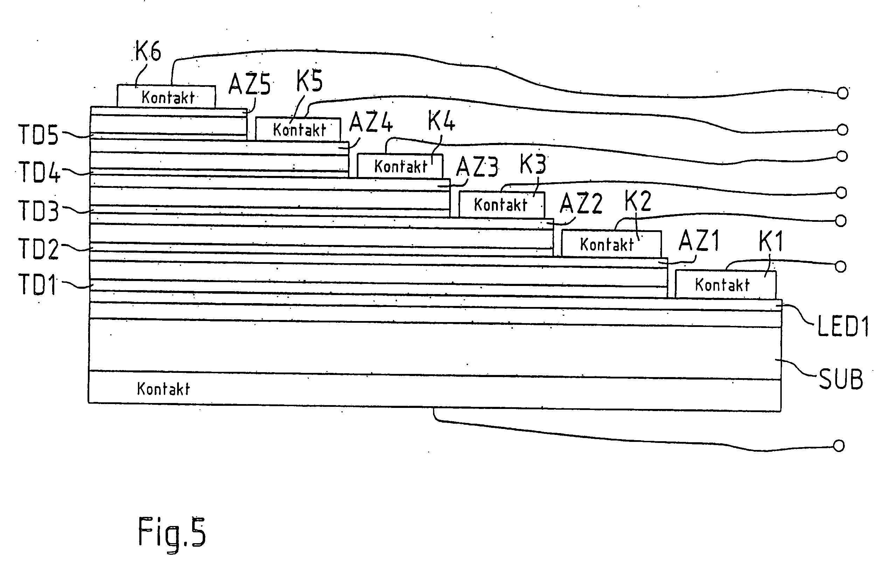

Fig. 5 zeigt eine schematische Anordnung einer lichtemittierenden Halbleitereinrichtung 24, umfassend ein Substrat SUB mit darauf aufgewachsenen licht emittierende Zonen AZ1 - AZ 6, die über Tunneldioden TD1 - TD5, welche zwischen den licht emittierende Zonen AZ1 - AZ6 angeordnet sind, seriell miteinander verschaltet sind. Die Ausführungsform der lichtemittierenden Halbleitereinrichtung 24 zeichnet sich dadurch aus, dass jede licht emittierende Zone AZ1 - AZ6 mit einem metallischen Kontakt K1 - K6 versehen ist, mit der Möglichkeit, dass innerhalb der Halbleiterstruktur, die auch als Multi-Wavelenght-Diodenstacks bezeichnet werden kann, bestimmte Wellenlängen-Peaks durch entsprechende Signale explizit ansteuerbar sind. Dadurch wird es möglich, Lichtemissionspeaks gezielt zu steuern bzw. zu regeln und zwar nach ihrer Helligkeit/Intensität, ihrer Farbe durch Auswahl der Peaks und nach bezweckter Mischfarbe oder gewünschten Bandemissionsteilbereichen.

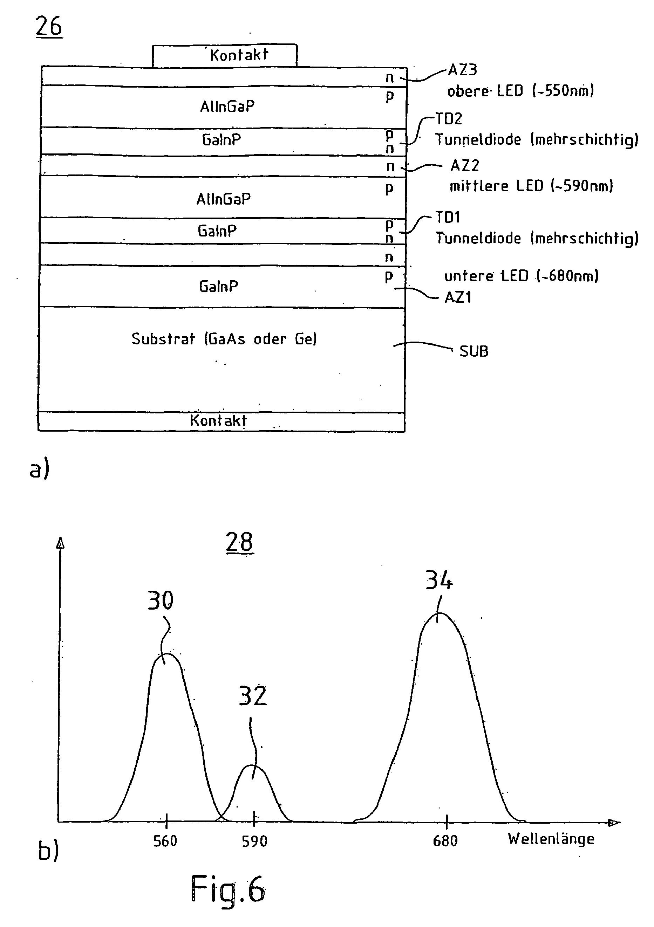

Fig. 6a zeigt eine schematische Anordnung einer lichtemittierenden Halbleitereinrichtung 26, welche als Mischfarben-LED bezeichnet werden kann und in der Farbe braun leuchtet. Die beispielhafte lichtemittierende Halbleitereinrichtung 26 umfasst ein Substrat SUB als GaAs- oder Ge-Substrat. Darauf wird eine GaInP-Diode AZ1 gewachsen, welche einen Wellenlängenbereich von ca. λ = 680 nm abdeckt. Darüber folgt eine np-Trenndiode TD1. Vorzugsweise ist die Trenndiode TD1 mehrschichtig ausgebildet mit einem höheren energetischen Bandgap als die darunter liegende AZ1 und dient als niederohmiger Verbindungswiderstand für die serielle Verschaltung zum weiteren pn-Übergang AZ2, der im Materialsystem AlInGaP eine Wellenlänge λ von ca. 590 nm ausgebildet ist. Schließlich wird wieder eine np-Trenndiode TD2 gewachsen und darauf wiederum ein dritter pn-Übergang als aktive Zone AZ3, welche mit dem Material AlInGaP mit einem Wellenlängenbereich λ von ca. 550 nm ausgebildet ist.

Der Fig. 6b ist eine Spektralverteilung 28 zu entnehmen, die den Verlauf von drei Farb-Peaks 30, 32, 34 zeigt, die für das menschliche Auge den Eindruck einer "braun-LED" darstellt. Da es verschiedene Brauntöne gibt, kommt es im Wesentlichen auf die verwendete Wellenlänge und die entstehende Intensität der Emissions-Peaks 30, 32, 34 an. Der braune Eindruck kann mehr rötlich, gelblich oder grünlich gestaltet werden.

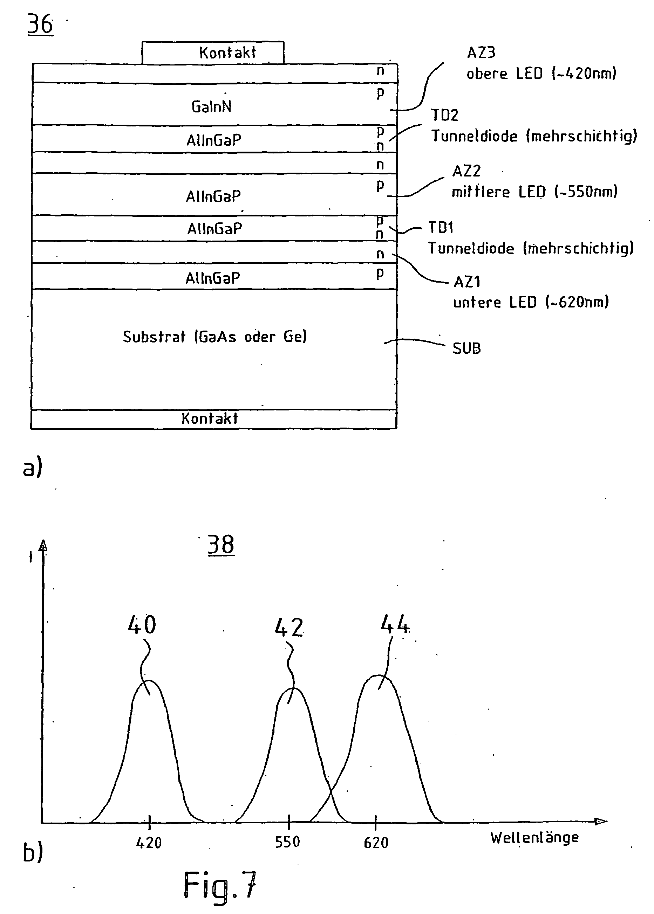

Fig. 7a zeigt den schematischen Aufbau einer Mischfarben-LED 36 zur Abgabe von weißem Licht. Die Mischfarben-LED 36 umfasst ein Substrat SUB, auf dem eine untere aktive Zone AZ1 aus AlInGaP-Material (Farbe rot) aufgewachsen ist, gefolgt von einer Tunneldiode TD1 aus AlInGaP-Material mit hohem Bandgap, einer mittleren licht emittierende Zone AZ2 aus AlInGaP-Material (Farbe grün), einer weiteren Tunnel-diode TD2 aus AlInGaP-Material (höheres energetisches Bandgap) und einer oberen licht emittierende Zone AZ3 aus GaInN-Material, oder AlGaInN-Material in einem Wellenbe-reich von λ ca. 400 nm bis 450 nm.

Eine Spektralverteilung 38 ist in Fig. 7b dargestellt und umfasst drei Farben-Peaks 40, 42, 44, die für das menschliche Auge den Eindruck einer LED mit der Farbe "weiß" erzeugen.

Da es viele Weiß-Eindrücke gibt, ist die verwendete Wellenlänge und die entsprechende Intensität der Emissions-Peaks 40, 42, 44 von entscheidender Bedeutung. Der weiße Eindruck kann mehr rötlich, grünlich oder bläulich gestaltet werden.

Des Weiteren kann der weiße Farbeindruck mit jeder Farbe der Normfarbtafel erzeugt werden, deren direkte Verbindungsstrecke durch den Weißpunkt läuft (bei zwei Farben). Werden drei Farben verwendet, wird ein Farbdreieck in der Normfarbtafel aufgespannt. Je nach Verwendung der Farbe und deren Intensität kann auch hierbei der gewünschte Weißpunkt erlangt werden. Nach dem oben genannten Prinzip sind nahezu beliebig viele Mischfarben möglich. Die Variation der Farben/Wellenlänge und deren Intensität müssen nach dem gewünschten Farbton abgestimmt werden.

Wie bereits zuvor erläutert, können die Mehr-Peak-Dioden bzw. Multi-Wavelenght-Dioden mit Trenndiodenkontakten TD1 - TDn oder mit leitfähigen Kontakten LK seriell verbunden werden, was am Beispiel einer weiß leuchtenden RGB-Diode 54 gemäß Fig. 8a beschrieben wird. Die Mischfarben-LED 54 besteht aus einem Substrat SUB, mit einem Kontakt K1 an seiner Unterseite und einer unteren licht emittierende Zone AZ1, gefolgt von einer Trenndiode TD1 und einer mittleren licht emittierende Zone AZ2, falls es bestimmten Materialsystemen nicht möglich ist, auf ein darunter liegen-des System aufzuwachsen, z. B. wegen zu großer Gitterfehlanpassung, Kristallstruktur, Wachstumstemperaturen usw., kann ein leitfähiger Kontakt LK wie z. B. Metallk-ontakt als serielle Verschaltung verwendet werden, Mittels Chip-on-Chip-Bonding kann dieser z. B. geklebt, gelötet, gebondet, geschweißt oder gedrückt werden, wodurch ein Kontakt zwischen den beiden Chips ermöglicht wird. Ein aus dem Substrat (SUB), der aktiven Zone AZ1, Trenndiode TD1 und mittlerer Leucht-diode AZ2 bestehender Dioden-Stack 58 ist nur mit einem Bond-Kontakt BK an der Oberfläche versehen. Ein weiterer Chip 56, umfassend ein Substrat SUB und eine Leuchtdiode mit der licht emittierende Zone AZ3, wird mit an seiner Unterseite angeordneten metallischen Kontakt K mit dem Bondkontakt BK des unteren Chips 58 verbunden, so dass ein gleitender Übergang entsteht.

Beispielsweise ist der Aufbau des unteren Chips dadurch gekennzeichnet, dass auf einem Substrat wie GaInP- oder AlInGaP-Diode als Leuchtdiode AZ1 aufgewachsen ist, mit einer Wellenlänge λ im Bereich von 600 nm bis 680 nm (rot). Darüber wird die np-Trenndiode TD1 aus AlInGaP-, AlGaAs- oder GaInP-Material gewachsen, die als niederohmiger Verbindungswiderstand für die serielle Verschaltung zum mittleren pn-Übergang AZ2 führt. Der mittlere pn-Übergang als Leuchtdiode LED2 ist als AlInGaP-Diode mit einer Wellenlänge λ im Bereich von 550 nm (grün) ausgebildet. Die Leuchtdiode AZ2 ist mit dem leitfähigen BK versehen. Durch diesen Chip 58 wird der obere Chip 56 befestigt, wie beispielsweise geklebt, gelötet, gebondet, geschweißt, gedrückt usw., wobei dieser die Farbe blau emittieren kann und beispielsweise aus einem Material wie GaInN-, AlGaInN- oder GaN- Material mit transparentem oder leitfähigem Substrat besteht. Die Diode AZ3 des oberen Chips 56 weist eine Wellenlänge λ im Bereich von ca. 400 bis 450 nm auf.

Eine Spektralverteilung 60 ist in Fig. 8b dargestellt und zeigt den Verlauf von 3-Farb-Peaks 62, 64, 66, die für das menschliche Auge den Eindruck einer weißen Farbe vermitteln.

Da es viele weiß-Kombinationen gibt, kommt es auch hier auf die verwendete Wellenlänge und die entstehende Intensität des Emissions-Peaks an. Der weiße Eindruck kann mehr rötlich, grünlich oder bläulich gestaltet werden.

Der weiße Farbeindruck kann mit jeder Farbe der Normfarbtafel erzeugt werden, deren direkte Verbindungsstrecke durch den Weißpunkt läuft (bei 2 Farben). Wenn drei Farben verwendet werden, wird ein Farbdreieck in der Normfarbtafel aufgespannt. Je nach Verwendung der Farbe und deren Intensität kann man auch hier an den gewünschten Weißpunkt gelangen. Nach diesen Prinzipien sind viele Mischfarben möglich zu realisieren. Die Variation der Farbe/Wellenlänge und der Intensität müssen für den gewünschten Farbton abgestimmt werden.

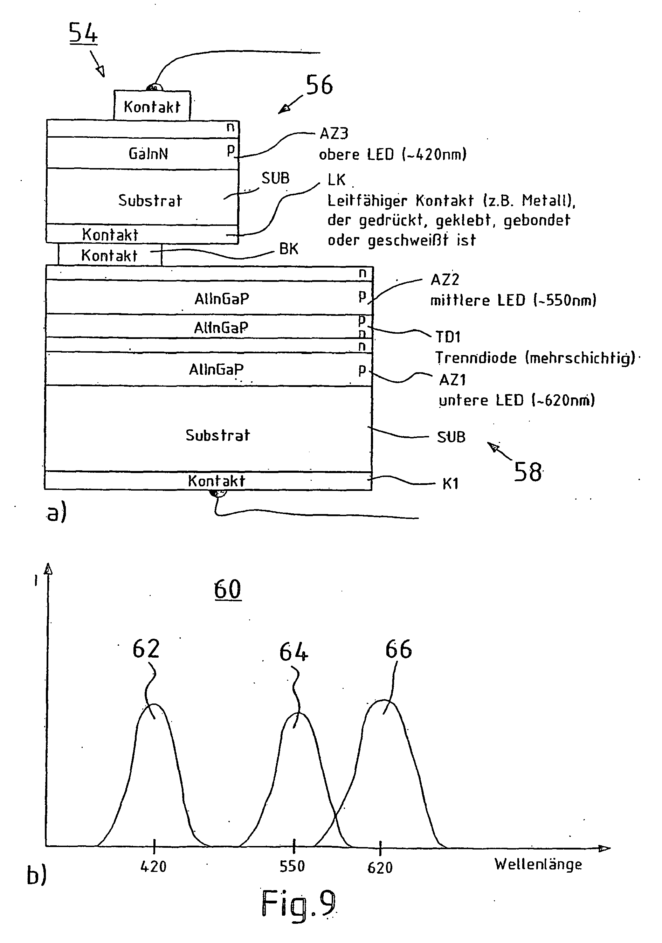

Eine weitere Ausführungsform einer lichtemittierenden Halbleitereinrichtung 68 ist in Fig. 9 dargestellt. Diese ermöglicht es, dass innerhalb des Strukturaufbaus bestimmte Intensitäten von Einzel-Peaks parzelliert werden und über die Flächenerhöhung bzw. Flächenvergrößerung eine Intensitätssteigerung ermöglicht wird. Zudem kann auch dadurch zum gesamten Aufbau auch nur ein Teilbereich des gewachsenen Aufbaus mit einem elektrischen Signal versorgt werden.

Auf einem Substrat SUB mit einem an der Unterseite angeordneten Kontakt K1 sind der gesamte Diodenaufbau 70 aufgewachsen. Durch technologische Trennung und technologischen Abtrag der gewachsenen Strukturen kann man einen verringerten Diodenaufbau 72 erhalten. Der erste Diodenaufbau 70 besteht aus einer Abfolge von Leuchtdioden AZ1 - AZ5, welche über Trenndioden TD1 - TD5 seriell mit einander verschaltet sind. Auf der obersten AZ5 ist ein Kontakt K2 aufgebracht.

Der Diodenaufbau 72 umfasst ferner parallel zu den Diodenschichten des Diodenstacks 70, Leuchtdioden AZ1 - AZ3 getrennt durch Trenndioden TD1, TD2. An der oberen Leuchtdiode AZ3 ist ein Kontakt K3 vorgesehen.

Durch diese Anordnung kann eine Erhöhung der Intensität aus Leuchtdiode AZ 1, AZ2 und Leuchtdiode AZ3 durch partielle Flächenvergrößerung erreicht werden.

Eine alternative Ausführungsform umfasst einen Strukturaufbau 74, wobei auf einem Substrat SUB zwei Diodenaufbauten 76, 78 angeordnet sind. Dabei besteht der Diodenstack, wie bereits zuvor erläutert, aus einer Abfolge von beispielsweise fünf Leuchtdioden AZ1 - AZ5, die jeweils über eine Trenndiode TD1 - TD5 verschaltet sind.

Der Diodenaufbau 78 besteht aus Leuchtdioden AZ1, AZ2, die über Trenndioden TD1 und TD2 seriell verschaltet sind. Der Strukturaufbau 74 zeichnet sich dadurch aus, dass durch den Teilbereich 78 das emittierende Licht zusätzlich mit einem elektrischen Signal versehen werden kann.

Die zuvor beschriebenen technologischen Varianten ermöglichen, dass innerhalb des Strukturaufbaus 68, 74 bestimmte Intensitäten-Peaks parzelliert werden können. Über die Flächenerhöhung kann zudem eine Intensitätssteigerung ermöglicht werden. Auch kann dadurch zum gesamten Aufbau 70, 72 bzw. 76, 78 ein Teilbereich mit einem elektrischen Signal versehen werden.

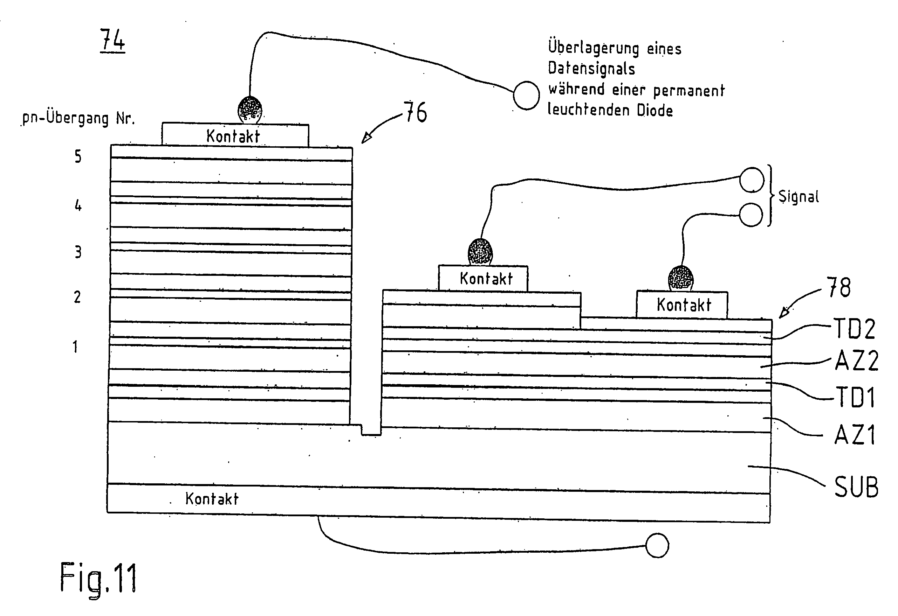

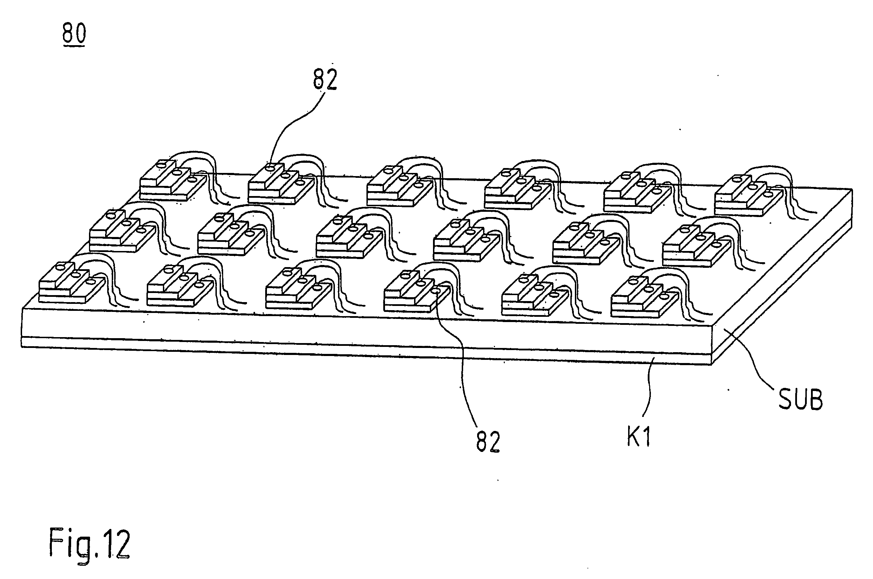

Alle zuvor aufgeführten systematischen und technologischen Varianten können in Chip-Bauweise (dies) oder als Display angewandt werden. Der schematische Aufbau eines Farbdisplays 80 ist beispielsweise in Fig. 11 dargestellt, umfassend ein Grundsubstrat SUB mit einem unteren Kontakt K1, wobei jeder Pixel 82 sogar entsprechende Farben selektiv ansteuerbar sind.

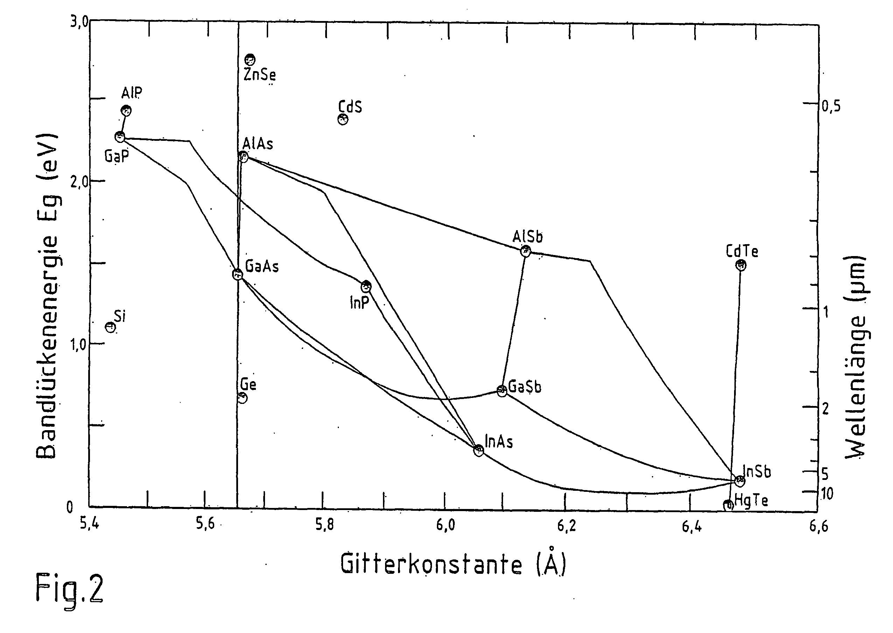

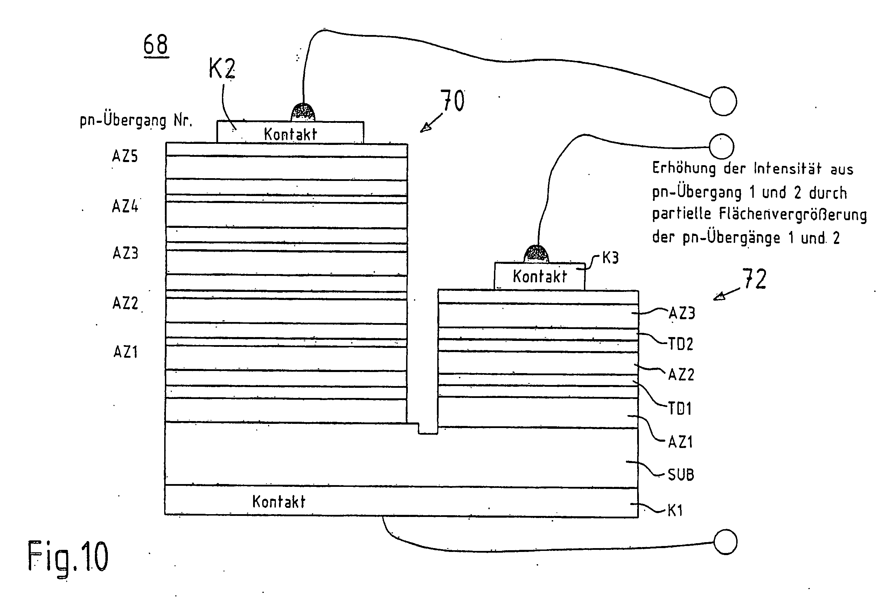

Die Pixel 82 umfassen dabei eine Struktur der oberen im Zusammenhang mit Fig. 1 - 10 beschriebenen Ausführungsformen. Dabei wird von einem RGB-Chip ausgegangen. Durch diese Display-Bauweise können Bildschirme hergestellt werden, die sehr hell leuchten und durch sehr kleine Pixel-Bauweise eine sehr hohe Auflösung aufweisen.

Das Prinzip der Multi-Wavelenght-Diode kann für die vielfältigsten Anwendungen eingesetzt werden, z. B.:
- im Beleuchtungsbereich durch die Herstellung von sehr hellen weißen LED's und Mischfarben-LED's mittels eines Chips,
- die Multi-Wavelenght-Photodioden (Sensoren) zur Überwachung von Mischfarben-Licht eingesetzt und detektieren die Zusammensetzung des Lichtspektrums,
- Bandemissionsdioden in der Sensorik (Spektralanalyse, Farbmessung und vieles mehr),
- das Ein-Chip-Design kann nach individuellen Anforderungen gefertigt werden,
- für kleine und mittelgroße Bildschirmdisplays mit sehr hoher Auflösung und Lichtstärke,
- zur Datenübertragung von verschiedenfarbigen Signalen bei gleicher Übertragungsfrequenz (Glasfaser-Übertragung) u. v. m.

## Patentansprüche

1. Licht-emittierende Zonen aufweisende Halbleiterstruktur in Form einer definiert viele Lichtwellenlängen emittierende Multiwavelength-Leuchtdiode (10, 16, 26, 36, 68, 74, 80), umfassend ein Substrat (SUB) mit zumindest zwei licht-emittierende Zonen (AZ1 - AZn), von denen jede eine Strahlung unterschiedlicher Wellenlänge emittiert, wobei eine erste (untere) licht-emittierende Zone (AZ1) auf eine Oberfläche des Substrates (SUB) aufgewachsen ist,
wobei zumindest eine weitere (obere) licht-emittierende Zone (AZ1 - AZn) epitaktisch aufgewachsen ist und wobei die licht-emittierende Zonen (AZ1 - AZn) über zumindest eine als niederohmiger Widerstand dienende Trennschicht (TD1 - TDn) von der unteren licht-emittierende Zone (AZ1) bis zu der oberen licht-emittierende Zone (AZn) seriell verschaltet sind, wobei die Trennschicht (TD1 - TDn) als gegenpolarisierter np- oder pn-Übergang in Form einer Trenndiode bzw. Tunneldiode (TD) ausgebildet ist, wobei zwischen der unteren licht-emittierende Zone (AZ1) und der oberen licht-emittierende Zone (AZn) ein oder mehrere weitere licht-emittierende Zonen (AZn) epitaktisch aufgewachsen sind,
wobei die unterste licht-emittierende Zone (AZ1) eine geringe energetische Bandlücke aufweist, wobei die folgenden licht-emittierende Zonen (AZ2 - AZn) jeweils eine höhere energetische Bandlücke aufweisen, als eine vorherige licht-emittierende Zone und wobei die zum Aufwachsen bzw. Epitaxieren der Trenndioden bzw. Tunneldioden (TD) verwendeten Halbleitermaterialien entweder einen indirekten Bandübergang aufweisen oder eine energetische Bandlücke, die jeweils etwas höher liegt als die der darunter liegenden verwendeten Halbleitermaterialien,
**dadurch gekennzeichnet,**
**dass** auf eine licht-emittierende Zone (AZn) eine Absorptionsschicht (AbsS) mit gleichem Material der pn-Schicht der licht-emittierende Zone (AZn) aufgewachsen ist.

2. Licht-emittierende Zonen aufweisende Halbleiterstruktur in Form einer definiert viele Lichtwellenlängen emittierende Multiwavelength-Leuchtdiode (10, 16, 26, 36, 54, 68, 74, 80), umfassend ein Substrat (SUB) mit zumindest einer unteren und einer oberen Licht-emittierenden Zone (AZ1 - AZn), von denen jede eine Strahlung unterschiedlicher Wellenlänge emittiert, wobei die untere Licht-emittierende Zone (AZ1) auf eine Oberfläche des Substrates (SUB) aufgewachsen ist, wobei zwischen der unteren Licht-emittierenden Zone (AZ1) und der oberen Licht-emittierenden Zone (AZn) eine oder mehrere weitere Licht-emittierende Zonen (AZn) angeordnet sind, wobei die untere Licht-emittierende Zone (AZ1) eine geringe energetische Bandlücke aufweist, wobei die folgenden Licht-emittierenden Zonen (AZ2 - AZn) jeweils eine höhere energetische Bandlücke aufweisen, als eine vorherige Licht-emittierende Zone und wobei die Licht-emittierenden Zonen (AZ1 - AZn) über zumindest eine als niederohmiger Widerstand dienende Trennschicht (TD1 - TDn) von der unteren Licht-emittierenden Zone (AZ1) bis zu der oberen Licht-emittierenden Zone (AZn) seriell verschaltet sind, wobei die Trennschicht (TD1 - TDn) als metallischer Kontakt (K) ausgebildet ist,
**dadurch gekennzeichnet,**
**dass** auf eine Licht-emittierende Zone (AZn) eine Absorptionsschicht (AbsS) mit gleichem Material der pn-Schicht der Licht-emittierenden Zone (AZn) aufgewachsen ist.

3. Licht-emittierende Zonen aufweisende Halbleiterstruktur nach Anspruch 1 oder 2,
**dadurch gekennzeichnet,**
**dass** das Material des Substrates (SUB) GaAs, Ge, InP, GaSb, GaP, InAs, Si, SiGe, SiC, SiGe : C, Saphir, oder Diamant ist.

4. Licht-emittierende Zonen aufweisende Halbleilerstruktur nach zumindest einem der vorhergehenden Ansprüch,
**dadurch gekennzeichnet,**
**dass** das Material der Licht emittierende Zonen (AZ1 - AZn) GaAs, GalnP (geeignete Kompositionen), AlGaAs (viele geeignete Kompositionen), GaInAs (geeignete Kompositionen), AlInGaP (viele geeignete Kompositionen), GaAsN, GaN, GaInN, InN, GaInAIN (geeignete Kompositionen), GaAISb, GaInAlSb, CdTe, MgSe, MgS, 6HSiC, ZnTe, CgSe, GaAsSb, GaSb, InAsN, 4H-SiC, α - Sn, BN, BP, BAs, AIN, ZnO, ZnS, ZnSe, CdSe, CdTe, HgS, HgSe, PbS, PbSe, PbTe, HgTe, HgCdTe, CdS, ZnSe, InSb, AIP, AlAs, AlSb, InAs und/oder AlSb ist oder eine oder mehrere dieser Materialien enthält.

5. Licht-emittierende Zonen aufweisende Halbleiterstruktur nach zumindest einem der vorhergehenden Ansprüche,
**dadurch gekennzeichnet,**
**dass** eine Bandemissionsdiode (16) folgenden Aufbau umfasst:
- ein GaAs- oder Ge-Substrat (SUB),
- eine auf das Substrat aufgewachsene GaAs-Diode (AZ1) (untere Diode),
- darüber in abwechselnder Reihenfolge eine auf die GaAs-Diode (AZ1) aufgewachsene Trenndiode wie GaInP-Trenndiode (TD) bzw. AlGaAs-Trenndiode (TD1 ... TDn) gefolgt von einer auf die Trenndiode aufgewachsenen GaInP-Diode (AZ3) bzw. AlGaAs-Diode (AZ3-AZn),
wobei der Bandemissionsbereich dadurch definiert wird, dass die Anzahl der Dioden (AZ1 - AZn), die Anzahl sowie deren Breite der Peaks einen zusammen liegenden Lichtemissionsbereich ausbildet, in der Art, wie er durch einen einzelnen Peak nicht erreicht werden könnte und somit ein resultierender Emissionsbereich entsteht.

6. Licht-emittierende Zonen aufweisende Halbleiterstruktur nach zumindest einem der vorhergehenden Ansprüche,
**dadurch gekennzeichnet,**
**dass** die einzelnen Licht emittierende Zonen (AZ1 - AZn) jeweils mit einem eigenen metallischen Kontakt (K) zum Anschluss einer Zuleitung versehen sind.

7. Licht-emittierende Zonen aufweisende Halbleiterstruktur nach zumindest einem der vorhergehenden Ansprüche,
**dadurch gekennzeichnet,**
**dass** eine Mischfarben-LED (26) (braun) folgenden Aufbau umfasst:
- ein GaA- oder Ge-Substrat (SUB),
- eine auf das Substrat aufgewachsene untere Licht emittierende Zone (AZ1) aus z. B. GaInP (auch AlGaInP),
- eine erste auf die untere Licht emittierende Zone aufgewachsene Trenndiode (TD1) aus GaInP oder AlGaInP,
- eine auf die Trenndiode aufgewachsene mittlere Licht emittierende Zone (AZ2) aus AlInGaP,
- eine zweite Trenndiode (TD2) und
- eine auf die zweite Trenndiode aufgewachsene obere Licht emittierende Zone (AZ3) aus AlInGaP.

8. Licht-emittierende Zonen aufweisende Halbleiterstruktur nach zumindest einem der vorhergehenden Ansprüche,
**dadurch gekennzeichnet,**
**dass** eine Mischfarben-LED (36) folgenden Aufbau umfasst:
- ein GaAa- oder Ge-Substrat (SUB),
- eine auf das Substrat aufgewachsene untere Licht emittierende Zone (AZ1) gefolgt von zwei weiteren Licht emittierende Zonen (AZ2 -AZn) zwischen denen jeweils eine Tunneldiode (TD1 - TDn) angeordnet ist und wobei die obere Licht emittierende Zone (AZn) einen metallischen Kontakt (K) zur Verbindung mit einem elektrischen Anschluss aufweist.

9. Licht-emittierende Zonen aufweisende Halbleiterstruktur nach zumindest einem der vorher-gehenden Ansprüche,
**dadurch gekennzeichnet,**
**dass** der zwischen den Lichte mittierende Zonen (AZ1 - Azn) angeordnete Metallkontakt (K, BK, LK) geklebt, gelötet, gedrückt, gebondet oder geschweißt ist.

10. Licht-emittierende Zonen aufweisende Halbleiterstruktur nach zumindest einem der vorhergehenden Ansprüche,
**dadurch gekennzeichnet,**
**dass** die untere Licht emittierende Zone (AZ1) aus einem AlInGaP-Material mit einer Wel-lenlänge von ca. 620 nm ist, dass die mittlere Licht emittierende Zone Zone (AZ2) ein AlInGaP-Halbleitermaterial mit einer Wellenlänge von ca. 550 nm ist und dass die obere Licht emittierende Zone Zone (AZ3) ein GaInN-Halbleitermaterial mit einer Wellenlänge im Bereich von ca. 400 bis 450 nm ist.

11. Licht-emittierende Zonen aufweisende Halbleiterstruktur nach zumindest einem der vorhergehenden Ansprüche,
**dadurch gekennzeichnet,**
**dass** eine oberste Licht emittierende Zone (AZn) einen Kontakt (BK) wie Bond-Kontakt aufweist.

12. Licht-emittierende Zonen aufweisende Halbleiterstruktur nach zumindest einem der vorhergehenden Ansprüche, licht-emittierende **dadurch gekennzeichnet,**
**dass** die n Zonen aufweisende Halbleiterstruktur ein Farbdisplay (80) bildet.

13. Licht-emittierende Zonen aufweisende Halbleiterstruktur nach zumindest einem der vorhergehenden Ansprüche,
**dadurch gekennzeichnet,**
**dass** das Farbdisplay (80) aus einer Vielzahl von lichtemittierenden Halbleitereinrichtungen (82) gemäß zumindest einem der Ansprüche 1 bis 12 ausgebildet ist, wobei ein Pixel (82) des Farbdisplays (80) einer lichtemittierenden Halbleitereinrichtung entspricht und wobei jeder Pixel (82) und die entsprechenden Farben selektiv ansteuerbar sind.

## Claims

1. Semiconductor structure with light-emitting zones in form of a multi-wavelength light emitting diode (10, 16, 26, 36, 68, 74, 80) that emits a defined number of light wavelengths, comprising a substrate (SUB) with at least two light-emitting zones (AZ1-AZn), each of which emits radiation of a different wavelength, a first (lower) light-emitting zone AZ1 being grown on a surface of the substrate (SUB), with a first (lower) light-emitting zone (AZ1) being grown on a surface of the substrate (SUB),
with at least one further (upper) light-emitting zone (AZ1-AZn) being grown epitaxially and with the light-emitting zones (AZ1-AZn) being serially connected from the lower light-emitting zone (AZ1) to the upper light-emitting zone (AZn) via at least one dividing layer (TD1-TDn) that serves as a low-impedance resistor, the dividing layer (TD1-TDn) being designed as a reciprocally biased np or pn junction in form of an isolation diode or tunnel diode (TD), between the lower light-emitting zone (AZ1) and the upper light-emitting zone (AZn) one or more additional light-emitting zones (AZn) being epitaxially grown, the lowest light-emitting zone (AZ1) having a low energetic band gap, the subsequent light-emitting zones (AZ2-AZn) having a higher energetic band gap than a previous light-emitting zone, and the semiconductor materials used for growing or epitax-ing the isolation diodes or tunnel diodes (TD) either having an indirect band junction or an energetic band gap, which in each case is somewhat higher than the semiconductor materials that are used beneath it,
**characterized in**
**that** an absorption layer (AbsS) having the same material as the pn layer of the light-emitting zone (AZn) is grown on a light-emitting zone (AZn).

2. A semiconductor structure with light-emitting zones in form of a multi-wavelength diode (10, 16, 26, 36, 54, 68, 74, 80) that emits a defined number of light wavelengths, comprising a substrate (SUB) with at least one lower and one upper light-emitting zones (AZ1-AZn), each of which emits radiation of a different wavelength, the lower light-emitting zone (AZ1) being grown on a surface of the substrate (SUB), one or more additional light-emitting zones (AZn) being arranged between the lower light-emitting zone (AZ1) and the upper light-emitting zone (AZn), the lower light-emitting zone (AZ1) having a low energetic band gap, the subsequent light-emitting zones (AZ2-AZn) each having a higher energetic band gap than a previous light-emitting zone, and with the light-emitting zones (AZ1-AZn) being serially connected from the lower light-emitting zone (AZ1) to the upper light-emitting zone (AZn) via at least one dividing layer (TD1-TDn) that serves as a low-impedance resistor, the dividing layer (TD1-TDn) being designed as a metallic contact (K),
**characterized in**
**that** an absorption layer (AbsS) having the same material as the pn layer of the light-emitting zone (AZn) is grown on an light-emitting zone (AZn).

3. Semiconductor structure with light-emitting zones according to claim 1 or 2,
**characterized in**
**that** the material of the substrate (SUB) is GaAs, Ge, InP, GaSb, GaP, InAs, Si, SiGe, SiC, SiGe: C, sapphire, or diamond.

4. Semiconductor structure with light-emitting zones according to at least one of the preceding claims,
**characterized in**
**that** the material of the light-emitting zones (AZ1-AZn) is or contains one or more of the following materials: GaAs, GaInP (suitable light-emitting compositions), AlGaAs (many suitable compositions), GaInAs (suitable compositions), AlInGaP (many suitable compositions), GaAsN, GaN, GaInN, InN, GaInAlN (suitable compositions), GaAlSb, GaInAlSb, CdTe, MgSe, MgS, 6HSiC, ZnTe, CgSe, GaAsSb, GaSb, InAsN, 4H-SiC, α-Sn, BN, BP, BAs, AlN, ZnO, ZnS, ZnSe, CdSe, CdTe, HgS, HgSe, PbS, PbSe, PbTe, HgTe, HgCdTe, CdS, ZnSe, InSb, AlP, AlAs, AlSb, InAs and/or AlSb.

5. Semiconductor structure with light-emitting zones according to at least one of the preceding claims,
**characterized in**
**that** a band emission diode (16) has the following structure:
• a GaAs or Ge substrate (SUB),
• a GaAs diode (AZ1) (lower diode) grown on the substrate,
• on top of this, in alternating sequence, an isolation diode grown on the GaAs diode (AZ1), such as a GaInP isolation diode (TD) or an AlGaAs isolation diode (TD1 ... TDn), followed by a GaInP diode (AZ3) or AlGaAs diode (AZ3-AZn) grown on the isolation diode,
the band emission range being defined in that the number of diodes (AZ1-AZn) and the number and the width of the peaks define a coincident light emission range as it could not be achieved with a single peak, thus a resulting emission range is created.

6. Semiconductor structure with light-emitting zones according to at least one of the preceding claims,
**characterized in**
**that** each of the individual light-emitting zones (AZ1-AZn) is equipped with its own metallic contact (K) for connection to a connecting lead.

7. Semiconductor structure with light-emitting zones according to at least one of the preceding claims,
**characterized in**
**that** a blended-color LED (26) (brown) has the following structure:
• a GaA or Ge substrate (SUB),
• a lower light-emitting zone (AZ1) made, for example, of GaInP (or AlGaInP), grown on the substrate,
• a first isolation diode (TD1) made of GaInP or AlGaInP, grown on the lower light-emitting zone,
• a center light-emitting zone (AZ2) made of AlInGaP, grown on the isolation diode,
• a second isolation diode (TD2) and
• an upper light-emitting zone (AZ3) made of AlInGaP, grown on the second isolation diode

8. Semiconductor structure with light-emitting zones according to at least one of the preceding claims,
**characterized in**
**that** a blended-color LED (36) has the following structure:
• a GaAa or Ge substrate (SUB),
• a lower light-emitting zone (AZ1) grown on the substrate, followed by two additional light-emitting zones (AZ2-AZn), between which a tunnel diode (TD1-TDn) is arranged, and the upper light-emitting zone (AZn) having a metallic contact (K) for connection with an electrical terminal.

9. Semiconductor structure with light-emitting zones according to at least one of the preceding claims,
**characterized in**
**that** the metal contact (K, BK, LK) arranged between the light-emitting zones (AZ1-AZn) is glued, soldered, pressed, bonded or welded.

10. Semiconductor structure with light-emitting zones according to at least one of the preceding claims,
**characterized in**
**that** the lower light-emitting zone (AZ1) is made of an AlInGaP material having a wavelength of approximately 620 nm, in that the center light-emitting zone (AZ2) is an AlInGaP semiconductor material having a wavelength of approximately 550 nm, and in that the upper light-emitting zone (AZ3) is a GaInN semiconductor material having a wavelength ranging from approximately 400 to 450 nm.

11. Semiconductor structure with light-emitting zones according to at least one of the preceding claims,
**characterized in**
**that** an uppermost light-emitting zone (AZn) has a contact (BK) such as a bond contact.

12. Semiconductor structure with light-emitting zones according to at least one of the preceding claims,
**characterized in**
**that** the semiconductor structure with the light-emitting zones forms a colored display (80).

13. Semiconductor structure with light-emitting zones according to at least one of the preceding claims,
**characterized in**
**that** the colored display (80) is formed from a plurality of light-emitting semiconductor devices (82) according to at least one of claims 1 through 12, one pixel (82) of the colored display (80) corresponding to a light-emitting semiconductor device, and each pixel (82) and the corresponding colors being selectively controllable.

## Revendications

1. Structure à semi-conducteurs présentant des zones électroluminescentes sous forme d'une diode électroluminescente à longueurs d'ondes multiples (10, 16, 26, 36, 68, 74, 80) émettant un nombre défini de longueurs d'ondes lumineuses, comprenant un substrat (SUB) avec au moins deux zones électroluminescentes (AZ1 - AZn) émettant chacune un rayonnement d'une longueur d'onde différente de l'autre, et dans laquelle une première zone électroluminescente (inférieure) (AZ1) est développée sur une surface du substrat (SUB),
sachant qu'au moins une autre zone électroluminescente (supérieure) (AZ1 - AZn) est développée par épitaxie et que les zones électroluminescentes (AZ1 - AZn) sont connectées en série depuis la zone électroluminescente inférieure (AZ1) jusqu'à la zone électroluminescente supérieure (AZn) par l'intermédiaire d'au moins une couche séparatrice (TD1 - TDn) faisant fonction de résistance de basse impédance, la couche séparatrice (TD1 - TDn) étant conçue en tant que transition np ou pn à pôles opposés sous forme de diode de blocage ou de diode tunnel (TD), sachant qu'entre la zone électroluminescente inférieure (AZ1) et la zone électroluminescente supérieure (AZn), une ou plusieurs zone(s) électroluminescente(s) (AZn) additionnelles est/sont développée(s) par épitaxie, que la plus basse zone électroluminescente (AZ1) présente un plus faible écart énergétique, que les zones électroluminescentes suivantes (AZ2 - AZn) présentent respectivement un écart énergétique plus élevé qu'une zone électroluminescente précédente, et que les matériaux semi-conducteurs utilisés pour développer ou épitaxier les diodes de blocage ou les diodes tunnel (TD) présentent soit une transition de bande indirecte, soit un écart énergétique qui est à chaque fois un peu plus élevé que ceux des matériaux utilisés situés en dessous,
**caractérisée en ce**
**que** sur une zone électroluminescente (AZn) est développée une couche absorbante (AbsS) avec le même matériau que celui de la couche pn de la zone électroluminescente (AZn).

2. Structure à semi-conducteurs présentant des zones électroluminescentes sous forme d'une diode électroluminescente à longueurs d'ondes multiples (10, 16, 26, 36, 68, 74, 80) émettant un nombre défini de longueurs d'ondes lumineuses, comprenant un substrat (SUB) avec au moins une zone électroluminescente inférieure et une zone électroluminescente supérieure (AZ1 - AZn) émettant chacune un rayonnement de longueur d'onde différente de l'autre, et dans laquelle la zone électroluminescente inférieure (AZ1) est développée sur une surface du substrat (SUB), sachant qu'entre la zone électroluminescente inférieure (AZ1) et la zone électroluminescente supérieure (AZn), une ou plusieurs zone(s) électroluminescente(s) (AZn) additionnelle(s) est/sont disposée(s), que la zone électroluminescente inférieure (AZ1) présente un plus faible écart énergétique, que les zones électroluminescentes suivantes (AZ2 - AZn) présentent respectivement un écart énergétique plus élevé qu'une zone électroluminescente précédente, et que les zones électroluminescentes (AZ1 - AZn) sont connectées en série depuis la zone électroluminescente inférieure (AZ1) jusqu'à la zone électroluminescente supérieure (AZn) par l'intermédiaire d'au moins une couche séparatrice (TD1 - TDn) faisant fonction de résistance de basse impédance, la couche séparatrice (TD1 - TDn) étant conçue en tant que contact métallique (K),
**caractérisée en ce**
**que** sur une zone électroluminescente (AZn) est développée une couche absorbante (AbsS) avec le même matériau que celui de la couche pn de la zone électroluminescente (AZn).

3. Structure à semi-conducteurs présentant des zones électroluminescentes selon la revendication 1 ou 2,
**caractérisée en ce**
**que** le matériau du substrat (SUB) est du GaAs, du Ge, de l'InP, du GaSb, du GaP, de l'InAs, du Si, du SiGe, du SiC, du SiGe : C, du saphir ou du diamant.

4. Structure à semi-conducteurs présentant des zones électroluminescentes selon au moins une des revendications précédentes,
**caractérisée en ce**
**que** le matériau des zones électroluminescentes (AZ1 - AZn) est du GaAs, du GaInP (compositions appropriées), de l'AlGaAs (nombreuses compositions appropriées), du GaInAs (compositions appropriées), de l'AlInGaP (nombreuses compositions appropriées), du GaAsN, du GaN, du GaInN, de l'InN, du GaInAlN (compositions appropriées), du GaAlSb, du GaInAlSb, du CdTe, du MgSe, du MgS, du 6HSiC, du ZnTe, du CgSe, du GaAsSb, du GaSb, de l'InAsN, du 4H-SiC, de l'α-Sn, du BN, du BP, du BAs, de l'AIN, du ZnO, du ZnS, du ZnSe, du CdSe, du CdTe, du HgS, du HgSe, du PbS, du PbSe, du PbTe, du HgTe, du HgCdTe, du CdS, du ZnSe, de l'InSb, de l'AlP, de l'AlAs, de l'AlSb, de l'InAs et/ou de l'AlSb, ou contient un ou plusieurs de ces matériaux.

5. Structure à semi-conducteurs présentant des zones électroluminescentes selon au moins une des revendications précédentes,
**caractérisée en ce**
**qu'**une diode émettrice de bande (16) comprend la structure suivante :
- un substrat GaAs ou Ge (SUB),
- une diode GaAs (AZ1) (diode inférieure) développée sur le substrat,
- au-dessus par ordre alterné une diode de blocage telle qu'une diode de blocage GaInP (TD) ou une diode de blocage AlGaAs (TD1 ... TDn) développée sur la diode GaAs (AZ1), suivie d'une diode GaInP (AZ3) ou d'une diode. AlGaAs (AZ3 - AZn) développée sur la diode de blocage,
sachant que la zone d'émission de bande est définie par le fait que le nombre de diodes (AZ1 - AZn), le nombre ainsi que la largeur des crêtes constituent une zone photo-émettrice d'un seul tenant, de manière telle qu'elle ne pourrait être atteinte par une crête isolée et qu'est ainsi créée une zone émettrice résultante.

6. Structure à semi-conducteurs présentant des zones électroluminescentes selon au moins une des revendications précédentes,
**caractérisée en ce**
**que** chaque zone électroluminescente (AZ1 - AZn) est munie d'un propre contact métallique (K) pour être connectée à un câble d'alimentation.

7. Structure à semi-conducteurs présentant des zones électroluminescentes selon au moins une des revendications précédentes,
**caractérisée en ce**
**qu'**une DEL de couleur mélangée (26) (brune) comprend la structure suivante :
- un substrat GaA ou Ge (SUB),
- une zone électroluminescente inférieure (AZ1) en p. ex. GaInP (également AlGaInP) développée sur le substrat,
- une première diode de blocage (TDI) en GaInP ou AlGaInP développée sur la zone électroluminescente inférieure,
- une zone électroluminescente médiane (AZ2) en AlInGaP développée sur la diode de blocage,
- une seconde diode de blocage (TD2) et
- une zone électroluminescente supérieure (AZ3) en AlInGaP développée sur la seconde diode de blocage.

8. Structure à semi-conducteurs présentant des zones électroluminescentes selon au moins une des revendications précédentes,
**caractérisée en ce**
**qu'**une DEL de couleur mélangée (36) comprend la structure suivante :
- un substrat GaAa ou Ge (SUB),
- une zone électroluminescente (AZ1) inférieure développée sur le substrat, suivie par deux autres zones électroluminescentes (AZ2 - AZn) entre lesquelles est à chaque fois disposée une diode tunnel (TD1 - TDn), sachant que la zone électroluminescente supérieure (AZn) présente un contact métallique (K) pour être reliée à un raccord électrique.

9. Structure à semi-conducteurs présentant des zones électroluminescentes selon au moins une des revendications précédentes,
**caractérisée en ce**
**que** le contact métallique (K, BK, LK) disposé entre les zones électroluminescentes (AZ1-AZn) est collé, brasé, pressé, lié ou soudé.

10. Structure à semi-conducteurs présentant des zones électroluminescentes selon au moins une des revendications précédentes,
**caractérisée en ce**
**que** la zone électroluminescente inférieure (AZ1) est constituée d'un matériau à base d'AlInGaP ayant une longueur d'onde d'environ 620 nm, que la zone électroluminescente médiane (AZ2) est constituée d'un matériau semi-conducteur à base d'AlInGaP ayant une longueur d'onde d'environ 550 nm et que la zone électroluminescente supérieure (AZ3) est constituée d'un matériau semi-conducteur à base de GaInN ayant une longueur d'onde comprise entre 400 et 450 nm env.

11. Structure à semi-conducteurs présentant des zones électroluminescentes selon au moins une des revendications précédentes,
**caractérisée en ce**
**que** l'une des zones électroluminescentes supérieures (AZn) présente un contact (BK) tel qu'un plot de liaison.

12. Structure à semi-conducteurs présentant des zones électroluminescentes selon au moins une des revendications précédentes,
**caractérisée en ce**
**que** la structure à semi-conducteurs présentant des zones électroluminescentes constitue un afficheur couleur (80).

13. Structure à semi-conducteurs présentant des zones électroluminescentes selon au moins une des revendications précédentes,
**caractérisée en ce**
**que** l'écran couleur (80) est formé par une pluralité de dispositifs électroluminescents (82) selon au moins une des revendications 1 à 12 sachant qu'un pixel (82) de l'afficheur couleur (80) correspond à un dispositif électroluminescent et que chaque pixel (82) et les couleurs correspondantes peuvent être activés de manière sélective.
